(19) **Europäisches Patentamt**

**European Patent Office**

**Office européen des brevets**

(11) **EP 1 236 050 B1**

(12) **EUROPEAN PATENT SPECIFICATION**

(45) Date of publication and mention
of the grant of the patent:
**28.07.2004 Bulletin 2004/31**

(51) Int Cl.⁷: **G01R 23/167**

(21) Application number: **00989919.6**

(86) International application number:
**PCT/EP2000/011983**

(22) Date of filing: **29.11.2000**

(87) International publication number:
**WO 2001/042798 (14.06.2001 Gazette 2001/24)**

(54) **ANALYSING SIGNALS**

ANALYSIEREN VON SIGNALEN

ANALYSE DE SIGNAUX

(84) Designated Contracting States:
**AT BE CH CY DE DK ES FI FR GR IE IT LI LU MC NL PT SE TR**

(30) Priority: **07.12.1999 GB 9928935**

(43) Date of publication of application:
**04.09.2002 Bulletin 2002/36**

(73) Proprietor: **Telefonaktiebolaget LM Ericsson (publ)**
**164 83 Stockholm (SE)**

(72) Inventor: **ATARIUS, Roozbeh**
**S-224 68 Lund (SE)**

(74) Representative: **Vigars, Christopher Ian**
**Haseltine Lake & Co.,**
**Imperial House,**
**15-19 Kingsway**
**London WC2B 6UD (GB)**

(56) References cited:
**US-A- 5 249 578**

• **PATENT ABSTRACTS OF JAPAN vol. 1995, no. 11, 26 December 1995 (1995-12-26) & JP 07 231244 A (MITSUBISHI ELECTRIC CORP), 29 August 1995 (1995-08-29)**
• **PATENT ABSTRACTS OF JAPAN vol. 017, no. 586 (P-1633), 26 October 1993 (1993-10-26) & JP 05 172869 A (SANYO ELECTRIC CO LTD), 13 July 1993 (1993-07-13)**

**Description**

TECHNICAL FIELD OF THE INVENTION

The present invention relates to analysing signals, and in particular to analysing the frequency properties of a signal.

DESCRIPTION OF THE RELATED ART

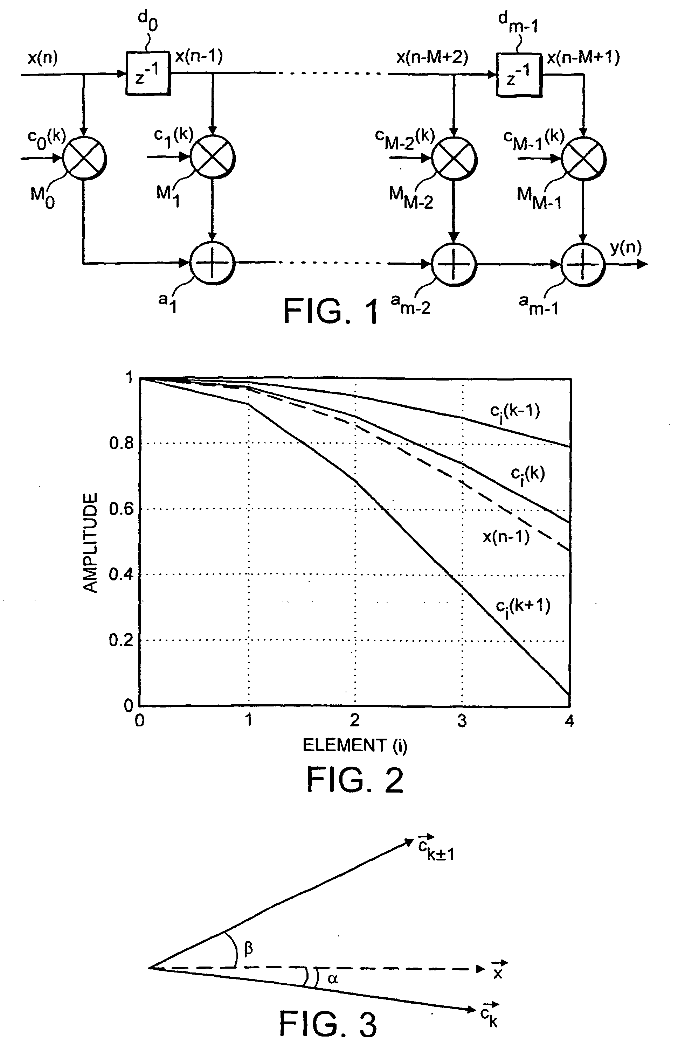

A filterbank can be used to analyse the frequency contents of a signal by comparing the signal against a set of filter coefficients. One such filterbank is illustrated in Figure 1 of the accompanying drawings, and will be described in detail below. Each set of filter coefficients represents a particular frequency content and results in a particular output when applied to the signal. The frequency contents of the signal can then be determined by studying the outputs of all the filters in the filterbank.

Some applications, such as estimation of Doppler spread for a Mobile Station (MS) in a mobile telecommunications system, require the exact frequency contents of the signal to be determined. For these applications many filters are required to improve the frequency resolution of the filterbank. US 5,249,578 describes a method of analysing frequency contents of an input signal received by a digital filter which comprises a plurality of multipliers connected to receive respective samples of the input signal and operable to multiply the samples by respective coefficients to produce a pluality of multiplied signals, and adding means operable to add the multiplied signals to give a digital filter signal.

SUMMARY OF THE INVENTION

The present invention presents an interpolation method for frequency analysis of a signal using a digital filter. The outputs of the filter are analysed and those sets of filter coefficients with frequency properties closest to the input are determined. These filter coefficients and their outputs are then used to determine the frequency contents of the input signal.

According to one aspect of the present invention, there is provided a method as defined by claim 1.

BRIEF DESCRIPTION OF THE DRAWINGS

Figure 1 illustrates a filterbank;

Figure 2 is a graph illustrating an input signal and coefficients of the filters in the filterbank of Figure 1;

Figure 3 illustrates vector notation of the signals of Figure 2; and

Figure 4 illustrates steps in a method embodying the present invention.

DESCRIPTION OF THE PREFERRED EMBODIMENT

A filterbank for frequency analysis of a signal can be interpreted as a set of matched filters in the time domain.

Figure 1 illustrates a realization of a filterbank which can be used to analyse the frequency contents of an input signal, $x(n)$. The filterbank comprises M multipliers $M_0...M_{M-1}$ which operate to multiply samples $x(n)...x(n-M+1)$ of an input signal by respective coefficients $c_0(k)...c_{M-1}(k)$. The first multiplier $M_0$ receives an undelayed sample $x(n)$ of the input signal, and the succeeding multipliers receive a successive delayed samples $x(n-1)...x(n-M+1)$ of the input signals. The filterbank also comprises a plurality of M-1 adders $a_1...a_{M-1}$ which operate to add together the outputs from the M multipliers. The filters are preferably provided by finite impulse response (FIR) filters having respective coefficients. The coefficients $c_0...c_{M-1}$ are provided as a set:

$$\mathbf{c}(k) \quad = \quad \left\{ C_0(k), C_1(k), ....., C_{M-1}(k) \right\} \qquad \qquad (1)$$

These coefficients are chosen with respect to frequency contents of input:

$$\mathbf{x} = \left\{ x(n), x(n-1), \ldots, x(n - M + 1) \right\} \tag{2}$$

Since the frequency contents of the input signal are not known, different sets of filter coefficients are employed in order to determine those contents. The frequency contents of the input signal are then estimated by identifying the set of coefficients that give the largest output of the filterbank. Using matched filters to estimate the frequency contents is an optimal method in maximum likelihood sense if the additive noise of the input signal is white and has Gaussian distribution. However, the complexity of the method is large if the frequency estimate is required to have high resolution.

In a method embodying the invention, this complexity is reduced by first specifying those two sets of filter coefficients which produce filterbank outputs "closest" to the input signal **x**. The accurate coefficient values are then found by interpolating between these two sets of filter coefficients. One of these two sets is specified as being the set that gives the largest magnitude output from the filterbank. However, the second set of coefficients does not necessarily give the second largest output magnitude. Considering the sets of coefficients and the input **x** as vectors, the set of coefficients closest to **x** can be found.

Figure 2 shows, by way of example, an input signal **x** which is closer to the set of filter coefficients c(k-1) than the set of coefficients **c**(k+1), even though the signal **x** is located between the sets of filter coefficients **c**(k) and **c**(k+1).

Therefore, it is necessary to study the relationship between two expressions:-

$$\frac{E\left\{ \mathbf{x}^T \mathbf{c}\,(k-1) \right\}}{E\left\{ \mathbf{c}\,(k)^T \mathbf{c}\,(k-1) \right\}} \tag{3}$$

$$\frac{E\left\{ \mathbf{x}^T c\,(k+1) \right\}}{E\left\{ \mathbf{c}\,(k)^T \mathbf{c}\,(k+1) \right\}} \tag{4}$$

For a better understanding of expressions (3) and (4), if **x** projects exactly onto **c**(k), then both (3) and (4) equal one. However, if the **c**(k) set does not map exactly to **x**, such that **x** is closer to the **c**(k+1) set (see Figure 2), then the numerator of expression (4) gets larger and so expression (4) becomes larger than expression (3).

The second set of filter coefficients can then be determined by selecting the set **c**(k-1) or **c**(k+1) that produces the larger of the expression (3) and (4). When the sets of filter coefficients are specified, the input signal frequency contents can be estimated by interpolating between the sets of filter coefficients. Considering **x**, **c**(k), and **c**(k±1) as vectors, the interpolation is performed according the following expression:

$$f = G\left( \frac{\alpha}{\beta} \right) \left( f_{k\pm 1} - f_k \right) + f_k, \tag{5}$$

where $\alpha$ and $\beta$ are angles of $(\vec{\mathbf{x}}, \vec{\mathbf{c}}(k))$ and $(\vec{\mathbf{x}}, \vec{\mathbf{c}}(k\pm 1))$, respectively. The vector representation is illustrated in Figure 3.

Function

$$G\left(\frac{\alpha}{\beta}\right)$$

relates $\alpha$ and $\beta$ to the frequencies represented by the sets $\mathbf{c}(k)$ and $\mathbf{c}(k\pm1)$, and $f_{k\pm1}$ and $f_k$ are determined by the chosen sets of filter coefficients.

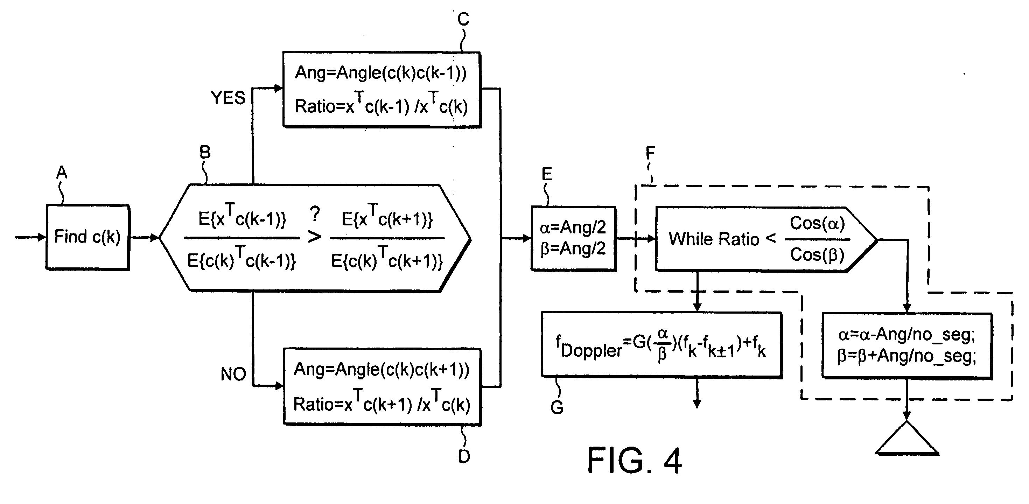

A method embodying the invention is illustrated in a flow chart of Figure 4, and comprises the steps of:

- Select the set of filter coefficients producing the largest filterbank output (Step A). This is projection of $\mathbf{x}$ on $\mathbf{c}(k)$ and is proportional to $\cos(\alpha)$ in Figure 3.

- Compare expressions (3) and (4) (Step B), in order to determine whether the signal $\mathbf{x}$ is located closer to $\mathbf{c}(k-1)$ or $\mathbf{c}(k+1)$.

- If signal $\mathbf{x}$ is closer to $\mathbf{c}(k-1)$,

$$\text{compute Angle} = \left(\vec{\mathbf{c}}(k), \vec{\mathbf{c}}(k-1)\right)$$

and

$$\text{Ratio} = \frac{\vec{x}^T . \vec{c}(k-1)}{\vec{x}^T . \vec{c}(k)}. \qquad \text{(Step C)}$$

- If signal $\mathbf{x}$ is closer to $\mathbf{c}(k+1)$,

$$\text{compute Angle} = \left(\vec{\mathbf{c}}(k), \vec{\mathbf{c}}(k+1)\right)$$

and

$$\text{Ratio} = \frac{\vec{x}^T . \vec{c}(k+1)}{\vec{x}^T . \vec{c}(k)}. \qquad \text{(Step D)}$$

- Initialise $\alpha$ and $\beta$ by setting each of them to half of Angle, as calculated. (Step E)

- Successively subtract a predetermined value from $\alpha$ and add the same value to $\beta$ until $\text{Ratio} \geq \frac{\cos(\alpha)}{\cos(\beta)}$.

The predetermined value is a small value which is determined by the resolution required by the filterbank.

- Estimate frequency spread by using updated $\alpha$ and $\beta$ values in expression (3) (Step G).

It will be appreciated that the invention can be employed, for example, in Doppler spread estimation, particularly where the radio channel is assumed to have Jakes spectrum. The channel correlation is estimated and analysed by a set of filter coefficients to determine the Doppler spread frequency.

## Claims

1. A method of analysing frequency contents of an input signal received by a digital filter which comprises a plurality (M) of multipliers ($M_0...M_{m-1}$) connected to receive respective samples ($x(n)...x(n-M+1)$) of the input signal and operable to multiply the samples by respective coefficients ($c_0(k)...c_{m-1}(k)$) to produce a plurality of multiplied sig-

nals, and adding means ($a_1...a_{m-1}$) operable to add the multiplied signals to give a digital filter output signal (y(n)), the method being **characterised by** the steps of:

determining a first set (c(k)) of said coefficients, which set gives the digital filter output signal having the largest magnitude;
determining a second set (c(i)) of said coefficients;
interpolating between the first and second sets of coefficients to give a third set of coefficients, which third set is indicative of the frequency contents of the input signal.

2. A method as claimed in claim 1, wherein determining the second set of coefficients comprises determining the set of coefficients ($\mathbf{c}$(i)) which gives the largest value of the expression:

$$\frac{E\left\{\mathbf{x}^{\mathbf{T}}\mathbf{c}\,(i)\right\}}{E\left\{\mathbf{c}\,(k)\mathbf{c}\,(i)\right\}}$$

wherein $\mathbf{x}^{\mathbf{T}}$ represents the input signal samples, $\mathbf{c}$(k) represents the first set of coefficients, and $\mathbf{c}$(i) represents the second set of coefficients.

3. A method as claimed in claim 1 or 2, wherein interpolating between the first and second sets of coefficients comprises:

representing the first and second sets in vector notation;
calculating an angle defined between the first and second sets of coefficients;
defining first and second angle values $\alpha, \beta$ to be equal to half the calculated angle;
calculating a ratio value:

$$\frac{x^{\mathbf{T}}c\,(i)}{x^{\mathbf{T}}c(k)}.$$

wherein $\mathbf{x}^{\mathbf{T}}$ represents the input signal, $\mathbf{c}$(k) represents the first set of coefficients, and $\mathbf{c}$(i) represents the second set of coefficients;
subtracting a predetermined value from the first angle value, and adding the predetermined value to the second angle value;
repeating the subtraction and addition of the predetermined value until the ratio of the respective cosines of the first and second angle values is less than or equal to the calculated ratio value; and
determining the third set of coefficients indicated by the calculated angle values.

**Patentansprüche**

1. Verfahren zum Analysieren von Frequenzinhalten eines Eingangssignals, das mittels eines Digitalfilters empfangen wird, welcher eine Vielzahl (M) von Multipliziergliedern ($M_0 ... M_{m-1}$) aufweist, welche angeschlossen sind, um entsprechende Abtastungen (x(n) ... x(n-M+1)) des Eingangssignals zu empfangen, und welche ausgelegt sind, um die Abtastungen mit entsprechenden Koeffizienten ($c_0(k) ... c_{m-1}(k)$) zu multiplizieren, um eine Vielzahl von multiplizierten Signalen zu erzeugen, und welcher Addier-Einrichtungen ($a_1 ... a_{m-1}$) aufweist, die ausgelegt sind, um die multiplizierten Signale zu addieren, um ein Digitalfilter-Ausgabesignal (y(n)) zu ergeben, wobei das Verfahren durch die folgenden Verfahrensschritte gekennzeichnet ist:

Bestimmen eines ersten Koeffizientensatzes (c(k)), wobei dieser Satz das Digitalfilter-Ausgabesignal mit der höchsten Magnitude ergibt;

Bestimmen eines zweiten Koeffizientensatzes (c(i));

Interpolieren zwischen dem ersten und zweiten Koeffizientensatz, um einen dritten Koeffizientensatz zu ergeben, wobei dieser dritte Satz die Frequenzinhalte des Eingangssignals anzeigt.

2. Verfahren nach Anspruch 1, in welchem der Verfahrensschritt des Bestimmens des zweiten Koeffizientensatzes das Bestimmen desjenigen Koeffizientensatzes (c(i)) aufweist, der den größten Wert des folgenden Ausdruckes liefert:

$$\frac{E\{X^T c(i)\}}{E\{c(k)c(i)\}} \ ,$$

bei dem $X^T$ die Eingangssignal-Abtastungen darstellt, $c(k)$ den ersten Koeffizientensatz darstellt und $c(i)$ den zweiten Koeffizientensatz darstellt.

3. Verfahren nach Anspruch 1 oder 2, in welchem der Verfahrensschritt des Interpolierens zwischen dem ersten und zweiten Koeffizientensatz folgendes aufweist:

Darstellen des ersten und zweiten Satzes in Vektorschreibweise;

Berechnen eines zwischen dem ersten und zweiten Koeffizientensatz definierten Winkels;

Definieren von ersten und zweiten Winkelwerten $\alpha$, $\beta$ und zwar derart, dass sie gleich der Hälfte des berechneten Winkeles sind;

Berechnen eines Verhältniswertes:

$$\frac{X^T c(i)}{X^T c(k)},$$

bei dem $X^T$ das Eingangssignal darstellt, $c(k)$ den ersten Koeffizientensatz darstellt und $c(i)$ den zweiten Koeffizientensatz darstellt;

Subtrahieren eines festgelegten Wertes von dem ersten Winkelwert und Addieren des festgelegten Wertes zu dem zweiten Winkelwert;

Wiederholen der Subtraktion und der Addition des festgelegten Wertes bis das Verhältnis der jeweiligen Kosinusausdrücke der ersten und zweiten Winkelwerte kleiner oder gleich dem berechneten Verhältniswert ist; und

Bestimmen des dritten Koeffizientensatzes, der mittels der berechneten Winkelwerte angezeigt wird.

**Revendications**

1. Procédé d'analyse de fréquences contenues dans un signal d'entrée reçu par un filtre numérique qui comporte une pluralité (M) de multiplieurs ($M_0...M_{m-1}$) connectés de façon à recevoir des échantillons respectifs ($x(n)...x(n-M+1)$) et pouvant fonctionner de façon à multiplier les échantillons par des coefficients respectifs ($c_0(k)...c_{m-1}(k)$) pour produire une pluralité de signaux multipliés, et des moyens d'addition ($a_1...a_{m-1}$) pouvant fonctionner de façon à additionner les signaux multipliés pour donner un signal de sortie ($y(n)$) du filtre numérique, le procédé étant **caractérisé par** les étapes qui consistent :

à déterminer un premier ensemble ($c(k)$) desdits coefficients, lequel ensemble donne le signal de sortie du filtre numérique ayant la plus grande amplitude ;
à déterminer un second ensemble ($c(i)$) desdits coefficients ;
à effectuer une interpolation entre les premier et second ensembles de coefficients pour donner un troisième ensemble de coefficients, lequel troisième ensemble est représentatif des fréquences contenues dans le signal d'entrée.

2. Procédé selon la revendication 1, dans lequel la détermination du deuxième ensemble de coefficients comprend la détermination de l'ensemble de coefficients (c(i)) qui donne la plus grande valeur de l'expression :

$$\frac{E\left\{\mathbf{x}^{\mathbf{T}}\mathbf{c}\,(i)\right\}}{E\left\{\mathbf{c}\,(k)\,\mathbf{c}\,(i)\right\}}$$

dans laquelle $x^T$ représente des échantillons d'un signal de sortie, c(k) représente le premier ensemble de coefficients et c(i) représente le deuxième ensemble de coefficients.

3. Procédé selon la revendication 1 ou 2, dans lequel l'interpolation entre les premier et deuxième ensembles de coefficients comprend :

la représentation des premier et second ensembles en notation vectorielle ;
le calcul de l'angle défini entre les premier et deuxième ensembles de coefficients ;
la définition de première et seconde valeurs d'angle $\alpha$, $\beta$ devant être égales à la moitié de l'angle calculé ;
le calcul d'une valeur de rapport :

$$\frac{x^T c\,(i)}{x^T c(k)}.$$

dans laquelle $x^T$ représente le signal d'entrée, c(k) représente le premier ensemble de coefficients et c(i) représente le deuxième ensemble de coefficients ;
la soustraction d'une valeur prédéterminée de la première valeur d'angle et l'addition de la valeur prédéterminée à la seconde valeur d'angle ;
la répétition de la soustraction et de l'addition de la valeur prédéterminée jusqu'à ce que le rapport des cosinus respectifs des première et seconde valeurs d'angle soit inférieur ou égal à la valeur calculée du rapport ; et
la détermination du troisième ensemble de coefficients indiqués par les valeurs d'angle calculées.

FIG. 1

FIG. 2

FIG. 3

FIG. 4